# EUROPEAN PATENT SPECIFICATION

(11) **EP 4 312 035 B1**
(45) Date of publication and mention of the grant of the patent: **02.09.2026**
(21) Application number: 22382714.8
(22) Date of filing: 26.07.2022
(51) Int. Cl.: G01R 27/00, H02S 50/10

(54) **DETERMINATION AND MONITORING OF SERIES RESISTANCE OF A PHOTOVOLTAIC DEVICE OR SYSTEM FROM VOLTAGE FACTOR**
BESTIMMUNG UND ÜBERWACHUNG DES VORWIDERSTANDS EINER PHOTOVOLTAISCHEN VORRICHTUNG ODER EINES SYSTEMS AUS EINEM SPANNUNGSFAKTOR
DÉTERMINATION ET SURVEILLANCE DE LA RÉSISTANCE SÉRIE D'UN DISPOSITIF OU D'UN SYSTÈME PHOTOVOLTAÏQUE À PARTIR DU FACTEUR DE TENSION

(43) Date of publication of application: 31.01.2024
(73) Proprietor: Fundación Tecnalia Research & Innovation, 20009 San Sebastián, Guipúzcoa (ES)
(72) Inventor: Santos Rodríguez, José Domingo, San Sebastián (ES); Riaño Fernandez, Sandra, San Sebastián (ES); Alonso Segade, Ricardo, San Sebastián (ES); Esteras Bejar, Miguel, San Sebastián (ES); Garcia Zambrano, Laura, San Sebastián (ES)
(74) Representative: Balder IP Law, S.L.

(56) References cited:
- ALI NASR ALLAH ALI ET AL: "A survey of maximum PPT techniques of PV systems", ENERGYTECH, 2012 IEEE, IEEE, 29 May 2012 (2012-05-29), pages 1 - 17, XP032237332, ISBN: 978-1-4673-1836-5, DOI: 10.1109/ENERGYTECH.2012.6304652
- BASTIDAS-RODRIGUEZ JUAN DAVID ET AL: "Model-Based Degradation Analysis of Photovoltaic Modules Through Series Resistance Estimation", IEEE TRANSACTIONS ON INDUSTRIAL ELECTRONICS, IEEE SERVICE CENTER, PISCATAWAY, NJ, USA, vol. 62, no. 11, 1 November 2015 (2015-11-01), pages 7256 - 7265, XP011586178, ISSN: 0278-0046, [retrieved on 20151007], DOI: 10.1109/TIE.2015.2459380

## Description

### TECHNICAL FIELD

The present disclosure relates to photovoltaic systems. More particularly, the present disclosure relates to a technique for determining and monitoring a series resistance of a photovoltaic device or system or a voltage factor associated therewith.

### BACKGROUND

Typical lifetime of photovoltaic (PV) systems is in the order of 20 to 30 years. During such period of time, the electrical components of the PV systems are exposed to harsh working conditions that include high temperatures, mechanical stress, and high irradiation levels. In many cases, these working conditions lead to the deterioration and early failure of PV modules, where the photoelectrical conversion takes place. Additionally, the harsh conditions can affect other components like that of the so-called balance of system (BOS), like junction boxes or cable connectors.

Many failure modes associated with the electrical components in a PV system may lead, directly or as side-effect, to an increase of the resistance to the current flow in the electrical circuit of the PV array. A higher series resistance, R_{S}, means a greater power dissipation as heat and, hence, performance loss of the PV system. In the worst-case scenario, the heat dissipation can lead to local overheating of the electrical components, with a severe risk of fire in a PV plant. Some of these failure modes usually observed on-field are: front delamination of PV module, module backsheet cracking, module cell interconnection failure, module metallization discoloration/corrosion, module junction box interconnection failure, and direct current (DC) interconnector mismatch.

Early identification of potential failure modes by means of an accurate determination and monitoring of R_{S} of the different PV arrays can noticeably improve the performance of the PV system during its lifespan, while reducing the operation and maintenance (O&M) costs. In that sense, the development of procedures for the routine check of the health state of the PV arrays through R_{S} is of interest for the PV industry.

US2018/131322A1 and Deceglie, Michael & Silverman, Timothy & Marion, Bill & Kurtz, Sarah. (2015). Real-Time Series Resistance Monitoring in PV Systems Without the Need for I-V Curves. IEEE Journal of Photovoltaics. 5. 1-4, describe the application of Suns-V_{OC} technique for real-time detection of series resistance changes in PV modules and systems connected to a PV inverter, which only provides the maximum power point current and voltage (I_{MPP} and V_{MPP}) of the I-V curve.

The Suns-V_{OC} method calculates the R_{S} by combining the current-voltage (I-V) curve with a hypothetical series resistance free I-V curve obtained from pairs open circuit voltage-short circuit current (V_{OC}-I_{SC}) measured at different irradiance levels.

Since the PV inverter only provides the I_{MPP} and V_{MPP} at different operation conditions (irradiance and module temperature), the RTSR (Real-Time Series Resistance) method provides a methodology to assess the R_{S}-free I-V curve at the actual I_{MPP} and module temperature. This methodology can take advantage of the fact that, when the PV inverter is in stand-by mode at very low irradiance (typically G<100 W/m²), it provides information of the open circuit voltage of the PV system.

The RTSR methodology implies the assessment of V_{OC} at an irradiance target (typically a 5-10% of the actual irradiance) and the actual module temperature. The calculation of the irradiance target assumes that the ratio between the actual I_{MPP} and short-circuit current is known (or can be estimated), while the temperature correction of V_{OC} is carried out assuming that the temperature coefficient of V_{OC} is known at each irradiance target (or can be estimated).

In some cases, these assumptions could be the cause of deviations or errors in the calculation of R_{S} that could lead to a loss of reliability in the monitoring process of R_{S}. This loss of reliability could mean the late detection of an increase of the series resistance, with the consequent power and economic losses. In other cases, this loss of reliability could mean unwanted false alarms that lead to an unnecessary deployment of the operation and maintenance workforce, with the consequent economic losses.

There is a huge interest on the development of new procedures for the assessment and monitoring of R_{S} in remote mode, using the basic information provided by e.g. a SCADA system of a standard PV installation. These procedures must be able to provide a high level of reliability during the monitoring process to effectively detect possible failure modes. This means the capability to assess R_{S} with a greater resilience against possible measurement errors, and a greater robustness against the lack of fulfilment of basic assumptions make in the calculation procedure.

### SUMMARY

A first aspect of the disclosure relates to a method as described in dependent claim 2 comprising:
computing, by one or more processors, a partial derivative of a voltage factor, VF, of a photovoltaic device or system with respect to a current at the maximum power generation, I_{MPP}, of the photovoltaic device or system from either:
   the voltage factor, VF, of the device or system, calculated by the one or more processors, as a ratio between: an open circuit voltage, V_{OC}, of the device or system, and a voltage at a maximum power generation, V_{MPP}, of the device or system; or
   data representative of pairs of I_{MPP} and voltage at a maximum power generation, V_{MPP}, of the device or system at a plurality of operating conditions, with the I_{MPP} and V_{MPP} of each pair being at same operating conditions;
characterized in that the method further comprises computing, by the one or more processors, a value for a series resistance, R_{S}, of the device or system at least based on: the computed partial derivative of VF, and at least one predetermined model characterizing a relationship between the R_{S} of the device or system and the partial derivative of VF;
wherein the method comprises:
   calculating, by the one or more processors, the voltage factor, VF, of the photovoltaic device or system as a ratio between: an open circuit voltage, V_{OC}, of the device or system, and a voltage at a maximum power generation, V_{MPP}, of the device or system;
   computing, by the one or more processors, a first ratio between: a product of a predetermined constant, n, associated with the device or system times a thermal voltage, V_{TH}, of the device or system for a predetermined temperature, and I_{MPP}; and
   computing, by the one or more processors, a second ratio between V_{MPP} and V_{OC}; and wherein:
      the computing, by the one or more processors, a partial derivative of a voltage factor, VF, of the photovoltaic device or system with respect to a current at the maximum power generation, I_{MPP}, of the photovoltaic device or system is from the voltage factor, VF, of the device or system, calculated by the one or more processors, as a ratio between: an open circuit voltage, V_{OC}, of the device or system, and a voltage at a maximum power generation, V_{MPP}, of the device or system; and
      the computing, by the one or more processors, a value for a series resistance, R_{S}, of the device or system is at least based on: a product of the partial derivative of VF and V_{OC}; and a product of the first ratio and the second ratio.

The determination of the series resistance of the photovoltaic device or system, PV device/system, is made without the provision of I-V curves unlike in other developments. Rather, the determination is based on the evaluation of the voltage factor, which might improve the reliability of the calculation of R_{S} when compared to other known procedures.

The voltage factor VF is contained in the so-called fill factor, which provides information about the electrical losses in the parasitic resistances of the PV device/system. The fill factor, FF, is defined as follows: $FF = \frac{{I}_{MPP} ⋅ {V}_{MMP}}{{I}_{SC} ⋅ {V}_{OC}}$

Any increase in these electrical losses causes a decrease in the I_{MPP}·V_{MPP} product of the fill factor. Specifically, a PV device/system affected by an increase of the R_{S} shows a progressive decrease in FF, mainly linked to a decrease in V_{MPP} without affecting V_{OC}. Therefore, the FF reduction and the associated power loss is determined by the VF decrease.

The calculation of the voltage factor requires the assessment of the open circuit voltage V_{OC} at the actual operation conditions of the PV device/system (instead of at multiple target irradiances like in other methodologies). The open circuit voltage may be provided by e.g. an electronic device that momentarily changes the operation point of the PV device/system to measure the open circuit voltage. The open circuit voltage could also be assessed from a multiparametric model that uses the actual meteorological data (irradiance, temperature, etc.), the design characteristics of the PV device/system (number of series connected PV modules, number of parallel strings, etc.), and the characteristics of the PV module (open circuit voltage at standard test conditions, temperature coefficient of V_{OC}, etc.) as input. Additionally, an algorithm configured to evaluate data provided by the PV inverter could identify those voltage values corresponding to open-circuit voltage usually observed at very low-irradiance conditions. These experimental data could be used as a more reliable input for a multiparametric model that allows the assessment of the open circuit voltage at any operation conditions. Likewise, by way of example, a classification algorithm can also be used to identify values of the open circuit voltage on a set of voltage values since, for instance, in many occasions two different clusters of values are present in such sets of voltage values.

The voltage factor presents a linear decrease with I_{MPP} for a given operation temperature T. This dependence between VF and I_{MPP} is a consequence of the increase in voltage drop in R_{S} as the current level increases, for example, due to a higher irradiance level.

**Further,** the slope of the dependence between VF and I_{MPP} for a given operation temperature also relates to R_{S}. In this sense, the partial derivative of VF with respect to I_{MPP} becomes more negative as R_{S} increases. Therefore, the R_{S} can be monitored by monitoring the derivative of the voltage factor with respect to the maximum power point current. This simplified procedure may allow monitoring of the series resistance without introducing assumptions about the actual short-circuit current of the PV device/system, thus improving the reliability of the monitoring process. In sum, the partial derivative can be used for monitoring the possible degradation of R_{S} of the PV device/system.

The predetermined constant, n, which multiplies the thermal voltage (computable, for instance, with formulae known in the art that are dependent on the temperature and the electrical charge or an electron), likewise influences the series resistance calculation. The predetermined constant is a value intended to characterize the electrical behavior of the PV device/system; particularly, the predetermined constant can be e.g. an ideality factor as known in the art.

With the computation of these parameters, the value for R_{S} can be computed, remotely from the PV device/system and online, i.e. upon request. The computation of the value for R_{S} is particularly simple when it does not require an estimation of I_{SC} in some embodiments.

The resulting value for R_{S} is a good approximation of the actual value for the series resistance. A relative error between the computed R_{S} value and the actual R_{S} value is typically below 12%.

So, as explained above, in some embodiments V_{OC} can be estimated for different operating conditions, i.e. for different values of G and T, with a multi-parametric model. Initially, the V_{OC} can be obtained from the PV device/system itself when the in-plane irradiance is low, e.g. below e.g. below 100 W/m². Under these conditions, the PV device/system is almost in open-circuit thus the voltage is an accurate approximation of V_{OC}.

In reference to the multi-parametric model, a non-limiting example is presented in the following standard equation to describe the irradiance, G, and module temperature, T, dependence of V_{OC}. Values with the subscript STC refers to the standard test conditions. The parameter *nVₜₕ* corresponds to the product of the predetermined constant (e.g. ideality factor) and the thermal voltage. Any other multiparametric physical or statistical model that correlates the open circuit voltage with the actual operation conditions could be used as well. ${V}_{OC} \left(G, T\right) = {V}_{OC} \left({G}_{STC}, {T}_{STC}\right) + {nV}_{th} ⋅ ln \left(\frac{G}{{G}_{STC}}\right) + {μ}_{{V}_{OC}} ⋅ \left(T-{T}_{STC}\right)$

Concerning the short circuit current, I_{SC}, evaluation thereof can be required for the calculation of R_{S}. For instance, a multiparametric model can be used based on the design characteristics of the PV device/system and additional data provided by e.g. one or more sensors, a SCADA system, etc. as known in the art, such as: irradiance, temperature, I_{MPP}, etc.

An exemplary, non-limiting multiparametric model to this end is presented next that relates the irradiance, G, a temperature of the PV device/system, T, to I_{SC}. Values with subscript STC refer to standard test conditions. TC[I_{SC}] corresponds to the temperature coefficient for I_{SC}. ${I}_{SC} = {I}_{SC , STC} ⋅ \frac{G}{{G}_{STC}} ⋅ \left(1+\frac{TC \left[{I}_{SC}\right]}{100}⋅\left(T-{T}_{STC}\right)\right)$

As it is apparent for the skilled person, other multiparametric physical or statistical models that correlates the short circuit current with the actual operation conditions could be used as well and also fall within the scope of the present disclosure.

It is noteworthy that the determination of R_{S} according to the present method appears to be more resilient to possible errors in the irradiance measurements, for example, errors related to possible orientation mismatch between the plane of the PV device/system and a sensor measuring irradiance when provided. This is even more so when the determination of R_{S} is made without considering the values of I_{SC}.

The method can be a computer-implemented method running in one or more computing devices. A single computing device may carry out the steps, or a plurality of computing devices may carry out the steps. When multiple computing devices carry out the steps, one or more steps can be carried out by a single computing device and one or more other steps can be carried out by two or more computing devices; or all steps are carried out by two or more computing devices. Distributed computing across the different computing devices whereby a computation is run in distributed manner and then combined is likewise possible.

In some embodiments, the predetermined constant *n* is an ideality factor representative of the electrical behavior of the device or system.

In some embodiments, in the step of computing the value for R_{S}, the value is a result of: ${R}_{S} = A + B$ where A at least has one term that is the product of the partial derivative and V_{OC}; and B at least has one term that is the product of the first ratio and the second ratio.

Owing to the aforesaid relationship between the partial derivative of VF with respect to I_{MPP}, the product term in A is in negative form, i.e. multiplied by -1 (minus one).

In some embodiments, in the step of computing the value for R_{S}, the value is a result of: ${R}_{S} = - {V}_{OC} ⋅ \frac{\partial VF}{\partial {I}_{MPP}} + \left(\frac{{nV}_{TH}}{{I}_{MPP}}\right) ⋅ \left(1-\frac{{V}_{MPP}}{{V}_{OC}}\right)$

In the above equation, *n* is preferably the ideality factor.

The above equation is provided under the assumption that there is a linear correlation between I_{SC} and I_{MPP}. And, thus, with the aforesaid equations, the value for R_{S} is more accurate owing to the different factors considered therein. A relative error between the computed R_{S} value and the actual R_{S} value is typically below 10%.

Further, when there is degradation in the R_{S} value, for example when the PV device/system has run out of part of its nominal useful life, the relative error is typically below 12%.

In some embodiments, the method further comprises:
computing, by the one or more processors, a third ratio between: n times V_{TH}, and a difference between a short-circuit current, I_{SC}, of the device or system and I_{MPP}; and
computing, by the one or more processors, a partial derivative of a difference between I_{SC} and I_{MPP} with respect to I_{MPP};
the value for R_{S} is at least further based on: a product of the third ratio and the partial derivative of the difference.

The difference between I_{SC} and I_{MPP} is approximated since the value of I_{SC} cannot be measured. And with said difference, the R_{S} value resulting from the computation is more accurate, especially at higher R_{S} values where there is no linear correlation between I_{SC} and I_{MPP}.

I_{SC} might be estimated from the operating conditions of the PV device/system, like in-plane irradiance G and module temperature T. In this sense, as known in the art, the photovoltaic array configuration (i.e. number of photovoltaic strings connected in parallel) and the characteristics of the PV device/system (I_{SC} at standard test conditions, STC, and temperature coefficient of I_{SC}) define I_{SC}. In any case, rather than estimating I_{SC}, the one or more processors estimate the difference between I_{SC} and I_{MPP}, which can be approximated by way of a mathematical expression. In some embodiments, the mathematical expression is a polynomial, whereas in some other embodiments it is a different function. The selected mathematical expression preferably approximates the difference as accurately as possible.

For example, but without limitation, the difference can be computed with the following equation corresponding to a second order polynomial: ${I}_{SC} - {I}_{MPP} = {C}_{2} {{I}_{MPP}}^{2} + {C}_{1} {I}_{MPP} + {C}_{0}$

In some embodiments, in the step of computing the value for R_{S}, the value is a result of: ${R}_{S} = A + B + C$ where A at least has one term that is the product of the partial derivative of VF with respect to I_{MPP}, and V_{OC}; B at least has one term that is the product of the first ratio and the second ratio; and C at least has one term that is the product of the third ratio and the partial derivative of the difference.

As aforementioned, due to the relationship between the partial derivative of VF with respect to I_{MPP}, the product term in A is in negative form.

In some embodiments, in the step of computing the value for R_{S}, the value is a result of: ${R}_{S} = - {V}_{OC} ⋅ \frac{\partial VF}{\partial {I}_{MPP}} + \left(\frac{{nV}_{TH}}{{I}_{MPP}}\right) ⋅ \left(\frac{{V}_{MPP}}{{V}_{OC}}\right) + \left(\frac{{nV}_{TH}}{{I}_{SC} - {I}_{MPP}}\right) ⋅ \left(\frac{\partial \left({I}_{SC}-{I}_{MPP}\right)}{\partial {I}_{MPP}}\right)$ where *n* is an ideality factor representative of an electrical behavior of the device or system.

With the aforesaid equations, the value for R_{S} may be more accurate owing to the different factors considered therein. A relative error between the computed R_{S} value and the actual R_{S} value is typically below 5%, and sometimes even below 3% or even equal to or below 1%. The relative error when there has been degradation in R_{S} rarely is greater, it rather can be even smaller.

Coming back to the previous example about the mathematical expression approximating the difference between I_{SC} and I_{MPP}, the partial derivative of the difference can be set as: $\frac{\partial \left({I}_{SC}-{I}_{MPP}\right)}{\partial {I}_{MPP}} = 2 {C}_{2} {I}_{MPP} + {C}_{1}$

Namely, the R_{S} value is the result of: ${R}_{S} = - {V}_{OC} ⋅ \frac{\partial VF}{\partial {I}_{MPP}} + \left(\frac{{nV}_{th}}{{I}_{MPP}}\right) ⋅ \left(\frac{{V}_{MPP}}{{V}_{OC}}\right) + \left(\frac{{nV}_{th}}{{I}_{SC} - {I}_{MPP}}\right) ⋅ \left(2{C}_{2}{I}_{MPP}+{C}_{1}\right)$

The values for coefficients C₂ and C₁ can be determined, for example, with a fitting algorithm, thereby providing the value for the series resistance.

In some embodiments, the ideality factor n is one of: estimated or simulated by the one or more processors, manually inputted by a user, a predetermined value, and obtained from a remote device via a communications link.

In some embodiments of the first aspect and/or the second aspect below, the method further comprises:
comparing, by the one or more processors, the value for R_{S} with one or more predetermined thresholds; and
executing or issuing, by the one or more processors, at least one action or command based on a result of the step of comparing.

In addition to calculating the R_{S} value, one or more actions can be executed at the PV device/system, at the computing device with the one or more processors, or at devices remote from the computing device like e.g. a server at a control center, a mobile phone, etc. For example, the operation of the PV device/system can be modified based on the comparison of the R_{S} value with the one or more predetermined thresholds, personnel are notified of a possible malfunction, etc.

In some embodiments of the first aspect and/or the second aspect below, the step of computing the value for R_{S} is conducted a plurality of times over a period of time, thereby providing a time evolution of the values of R_{S} (and also for VF and the derivative of VF with respect to I_{MPP}).

The R_{S} and/or the derivative of VF can be periodically calculated within a sliding time window to monitor their evolution. The obtained values can be compared with reference values for the R_{S} and/or the derivative of VF previously calculated under normal operation conditions of the PV device/system. Reference values for comparison can also be obtained, for example, from physics modelling or any other approach that uses the characteristics of the PV device/system.

By computing a plurality of R_{S} values as the time goes by, R_{S}, VF and/or the partial derivative of VF with respect to I_{MPP} can be monitored over time to detect possible degradation or fault modes in the PV device/system.

In some embodiments, the method further comprises:
comparing, by the one or more processors, at least one of: the time evolution (of the values of R_{S}), a time evolution of the values of VF, and a time evolution of the values of the partial derivative of VF with respect to I_{MPP} with one or more predetermined thresholds or predetermined curves; and
executing or issuing, by the one or more processors, at least one action or command based on a result of the step of comparing the time evolution.

In addition to monitoring the R_{S} value over time, the VF value over time and the partial derivative (of VF with respect to I_{MPP}) value over time, one or more actions can be executed at the PV device/system, at the computing device with the one or more processors, or at devices remote from the computing device.

Upper and lower predetermined thresholds or curves (control limits) can be defined, for example, based on statistical analysis of the data under normal operation conditions of the PV device/system. Thus, a control chart can be used to detect failure modes when the respective time evolution values fall outside of the lower and upper control limits. As it will be noted by the skilled person, any other kind of statistical algorithm can be used to detect possible worsening trends in the monitored parameters.

With regards to VF, the predetermined thresholds may for instance be provided by way of a model for predicting the instantaneous VF, with the predicted value of VF being dependent upon instantaneous irradiance, temperature, I_{MPP}, and reference values for R_{S} and the derivative of VF. That way, discrepancies between predicted and experimental instantaneous VF values can be used as an early warning of possible changes in R_{S} and/or the derivative of VF.

An exemplary model for VF is presented in the following equation that provides its value based on the instantaneous I_{MPP} produced by the PV device/system, and the instantaneous temperature of the PV device/system. Values with subscript STC refer to standard test conditions. The parameter µ_{VF} corresponds to the temperature coefficient of VF. $VF \left({I}_{MPP}, T\right) = VF \left({I}_{MPP , STC}, {T}_{STC}\right) + \frac{{dVF}_{STC}}{{dI}_{MPP}} ⋅ \left({I}_{MPP}-{I}_{MPP , STC}\right) + {μ}_{VF} ⋅ \left(T-{T}_{STC}\right)$

In some embodiments of the first aspect and/or the second aspect below, the at least one action or command (resulting from the step of comparing the value for R_{S} and/or from the step of comparing the time evolution) comprises one or more of: generating an alarm signal, transmitting an alarm signal to an electronic device, transmitting a request for maintenance tasks to an electronic device, reducing the electric current in the PV device or system preferably to put it in open circuit conditions, and actuating one or more electrical protection devices to disconnect the PV device/system from other PV devices/systems and/or from an electrical system.

When alarm signals are generated or transmitted, the alarm signal may contain information of the affected PV device/system, a temporal window in which the deviation was detected, a statistical summary of the operating conditions of the PV device/system during the operation thereof that resulted in the execution or issuance of the action or command, severity in terms of percentage of deviation from a reference R_{S} and/or a reference $\frac{\partial VF}{\partial {I}_{MPP}}$, among other possible parameters of interest.

The alarm signal can be transmitted to a device of the operation and maintenance workforce and/or generated for local warning by way of e.g. audible signals, visible signals, etc. to check the existence of a possible failure mode and minimize the impact of the associated power losses.

A notification for requesting or scheduling maintenance tasks can also be transmitted to a device of the operation and maintenance workforce for prompt checking of any problematic behavior that the PV device/system may feature.

To avoid running the risk of damaging the PV device/system itself or other parts of the electrical system that the PV device/system is connected to, the current in the PV device/system may be reduced (even all the way down to zero) so as to reduce the power dissipated in the degraded series resistance, or be disconnected from the electrical system by adjusting the configuration of electrical protection devices, for example by opening protection switches in the electrical circuit that connects the PV device/system to the electrical system.

In case that the result of the comparison reaches a certain predetermined threshold, at least one processor (which may be the one or more processors or different ones) may be configured to control an operation point of the PV device/system to progressively reduce the maximum power point current until a safety operation is obtained. A safety parameter can be defined in terms of dissipated power in the degraded series resistance or any other predefined parameter. The control of the maximum power point tracker can be carried out by means of e.g. a maximum power point tracker (of e.g. an inverter) or by an electronic device adapted for this function.

In some embodiments of the first aspect and/or the second aspect below, the method further comprises estimating, by the one or more processors, degradation of the R_{S} of the device or system by evaluating the partial derivative of VF with respect to I_{MPP}.

In some embodiments of the first aspect and/or the second aspect below, the method further comprises determining, by the one or more processors and with respect to the photovoltaic device or system, one or more of: V_{OC}, V_{MPP}, and I_{MPP}. In some embodiments, the determining step also comprises determining I_{SC} with respect to the photovoltaic device or system.

In some embodiments of the first aspect and/or the second aspect below, the determination is based on measurements provided by one or more sensors measuring one or more of: I_{MPP}, V_{MPP}, V_{OC}, in-plane irradiance G and temperature T. In some embodiments, the one or more sensors comprises an inverter.

The sensor(s) may or may not be part of the PV device/system. For example, magnitudes G and T could be measured by sensors remote from the PV device/system (preferably as close to the PV device/system as possible to have values that are similar or are the same as the ones that could be measured by a sensor that is part of the PV device/system) and be supplied to the one or more processors for conducting the calculations.

In some embodiments of the first aspect and/or the second aspect below, the photovoltaic device or system is or comprises one of the following photovoltaic devices or systems: a solar cell, a module, a string, an array, an inverter, and a combination thereof.

A second aspect of the disclosure relates to a method according to claim 1 comprising
computing, by one or more processors, a partial derivative of VF with respect to a current at the maximum power generation, I_{MPP}, of a photovoltaic device or system from either:
   a voltage factor, VF, of the device or system, calculated by the one or more processors, as a ratio between: an open circuit voltage, V_{OC}, of the device or system, and a voltage at a maximum power generation, V_{MPP}, of the device or system; or
   data representative of pairs of I_{MPP} and voltage at a maximum power generation, V_{MPP}, of the device or system at a plurality of operating conditions, with the I_{MPP} and V_{MPP} of each pair being at same operating conditions; and
computing, by the one or more processors, a value for a series resistance, R_{S}, of the device or system at least based on: the computed partial derivative (of VF with respect to I_{MPP}), and at least one predetermined model characterizing a relationship between the R_{S} of the device or system and a partial derivative (of VF with respect to I_{MPP}).

The derivative of VF presents a strong correlation with the value of R_{S}, providing a key parameter to identify possible failure modes that affect the R_{S}. In general, a mathematical relationship can be found to describe the dependence between the series resistance and the derivative of VF.

One or more mathematical expressions establishing the predetermined model(s) can be obtained by means of a physical model that describes an optoelectronic behavior of the PV device/system. Alternatively, one or more mathematical expressions can be obtained by means of the single-diode model that describes a physical model of the PV device/system.

The predetermined model(s) may be defined by way of digital simulations intended to characterize the behavior of R_{S} with respect to the derivative of VF, or even by way of experimental tests. The latter is generally complex because it requires the PV device/system under test to undergo changes in its R_{S} for an adequate modeling thereof, and R_{S} cannot be typically modified in a controlled manner.

As the relationship between R_{S} and the derivative of VF is substantially linear, a mathematical expression of the predetermined model(s) may take, for example but without limitation, the form of the following equation: ${R}_{S} = A \frac{\partial VF}{\partial {I}_{MPP}} + B$

Constants A and B are to be computed by means of the simulations or experimental tests conducted for the characterization of the PV device/system.

It is noted that R_{S} varies with temperature, hence a mathematical expression as the previous one is defined for a given temperature, or a mathematical expression that is dependent upon temperature can be alternatively defined.

The plurality of pairs of I_{MPP}-V_{MPP} values may be experimental data, namely values of the PV device/system that are measured, and/or synthetic data, namely values of the PV device/system that are digitally obtained by way of e.g. simulations. In case of the latter, the data are synthetic data that may be digitally obtained by the same one or more processors computing the partial derivative of VF, or by some other one or more processors in which case the obtained data are provided to the one or more processors computing the partial derivative of VF.

Like the method of the first aspect, the method of the second aspect can be a computer-implemented method running in one or more computing devices.

A third aspect of the disclosure relates to a data processing device or system comprising means for carrying out a method according to the first aspect or the second aspect.

The data processing device or system may be a computing device or system configured to conduct steps of a method according to the first aspect or the second aspect.

For instance, but without limitation, the device may comprise a single computing device with e.g. one or more processors, one or more memory units, both configured to conduct the steps, for instance by way of one or more computer programs or computer code configured to that end.

By way of another example, the data processing system may comprise a plurality of computing devices communicatively coupled in such a way as to perform distributed computing.

The data processing device or system may be part of the PV device/system itself or of an inverter associated therewith, or be remote therefrom but communicatively coupled to obtain the parameters.

A fourth aspect of the disclosure relates to a photovoltaic device or system comprising a data processing device or system according to the third aspect.

In some embodiments, the photovoltaic device or system is or comprises one of the following photovoltaic devices or systems: a solar cell, a module, a string, an array, an inverter, and a combination thereof.

A fifth aspect of the disclosure relates to a computer program product or a data carrier signal carrying the computer program product, the computer program product having instructions which, when executed by a computing device, cause the computing device to perform a method according to the first aspect and/or the second aspect.

In some embodiments, the computer program product is embodied on a non-transitory computer-readable medium or a computer-readable data carrier has the computer program product stored thereon.

A sixth aspect of the disclosure relates to a data carrier signal carrying a computer program product according to the fifth aspect.

### BRIEF DESCRIPTION OF THE DRAWINGS

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The drawings include the following figures:
Figure 1 shows the evolution of an I-V curve of an exemplary photovoltaic device/system with respect to its series resistance, R_{S}. A progressive decrease of the fill factor and the voltage factor is graphically shown as R_{S} is increased.
Figure 2 shows the VF dependence with the I_{MPP} (for simplicity normalized to its value under standard test conditions, STC) at different ranges of an exemplary PV device/system temperature for a constant series resistance, R_{S}.
Figure 3 shows the VF dependence with the I_{MPP} (for simplicity normalized to its value under standard test conditions, STC) at different series resistance values, R_{S}, for an exemplary constant PV device/system temperature.
Figure 4 shows the derivative of the voltage factor with respect to I_{MPP}, $\frac{\partial VF}{\partial {I}_{MPP}} ,$, dependence with the PV device/system temperature for a given series resistance Rs
Figure 5 shows V_{MPP} evolution with the irradiance level of an exemplary PV device/system as measured by e.g. a photovoltaic inverter. From this data, the values of open-circuit voltage V_{OC} can be determined with a clustering technique.
Figure 6 shows the evolution of the difference of short-circuit current, I_{SC}, of an exemplary photovoltaic device or system and I_{MPP}, with I_{MPP} itself (for simplicity normalized to its value under standard test conditions, STC). Dependence is presented for two at different ranges of PV device/system temperature for two different R_{S} values.
Figure 7 shows a comparison of R_{S} values according to different embodiments and a prior art method. R_{S} values are assessed from the very same experimental data at different in-plane irradiance levels
Figure 8 shows the partial derivative of the voltage factor with respect to I_{MPP}, $\frac{\partial VF}{\partial {I}_{MPP}}$*,* dependence with the series resistance R_{S} for an exemplary PV device/system temperature.
Figure 9 diagrammatically shows a system with an exemplary PV device/system whose series resistance is monitored.

### DETAILED DESCRIPTION

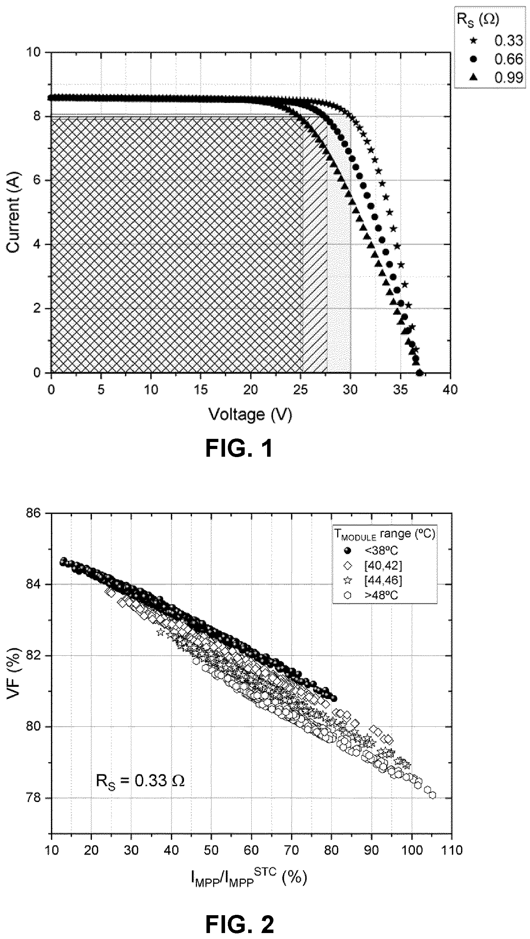

Figure 1 shows graphically the evolution of the fill factor and voltage factor of a PV device/system with respect to its series resistance, R_{S}. Particularly, Figure 1 shows an I-V curve for a PV device/system, with the generated maximum power being represented by the shaded area, whose top right corner is defined by the maximum power point (I_{MPP}, V_{MPP}).

As it can be seen in the graph, the shaded area decreases as the Rs is increased mainly because of a decrease of V_{MPP} while V_{OC} is unaffected, meaning a decrease of the voltage factor VF.

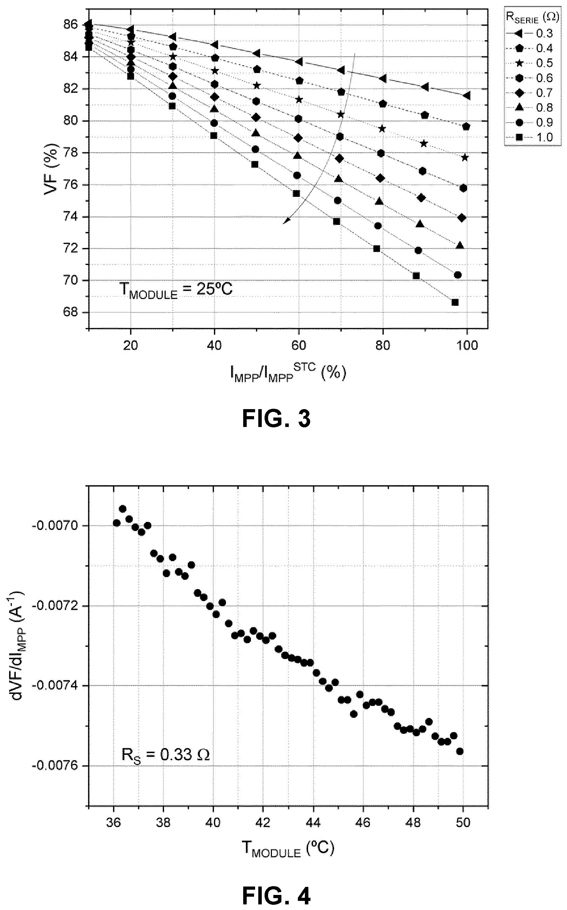

Figures 2 and 3 show relationships between VF and I_{MPP} of a photovoltaic device/system. In Figure 2, the relationship is shown as a function of temperature whereas in Figure 3 it is shown as a function of R_{S}. For the sake of a clearer representation only, in the horizontal axis the ratio I_{MPP}/ I_{MPP,STC} is represented as a percentage.

Several operation temperatures for the PV device/system are shown in Figure 2, ranging from 38 °C or less, up to 48 °C or more. For each of these operation temperatures, the behavior of VF relative to I_{MPP} features the same trend. Particularly, VF decreases substantially linearly as I_{MPP} gets larger.

The dependence of VF with respect to I_{MPP} is a consequence of the increase in voltage drop in R_{S} as the current level increases, for example, due to a higher irradiance level.

A similar behavior also exists for different values of R_{S} as seen in Figure 3, but unlike with temperatures, the slope of VF versus I_{MPP} varies depending on the value of R_{S}. The curves are represented for R_{S} values ranging from 0.3 Ω up to 1.0 Ω. The slopes of VF are all negative, but they are more negative for larger R_{S} values and are less negative (i.e. closer to zero) for smaller R_{S} values.

Based on this behavior, the slope of VF versus I_{MPP} can be used to monitor how R_{S} of the PV device/system degrades over time.

Figure 4 shows a relationship between the derivative of the voltage factor with respect to I_{MPP}, and temperature.

Further to the graph of Figure 2, in Figure 4 the graph illustrates how the derivative of VF becomes more negative for greater temperatures that the PV device/system is at. The derivative of VF is represented for a same value of R_{S}, in this particular example for a value of R_{S} of 0.33 Ω. The evolution of the derivative with temperature is substantially linear.

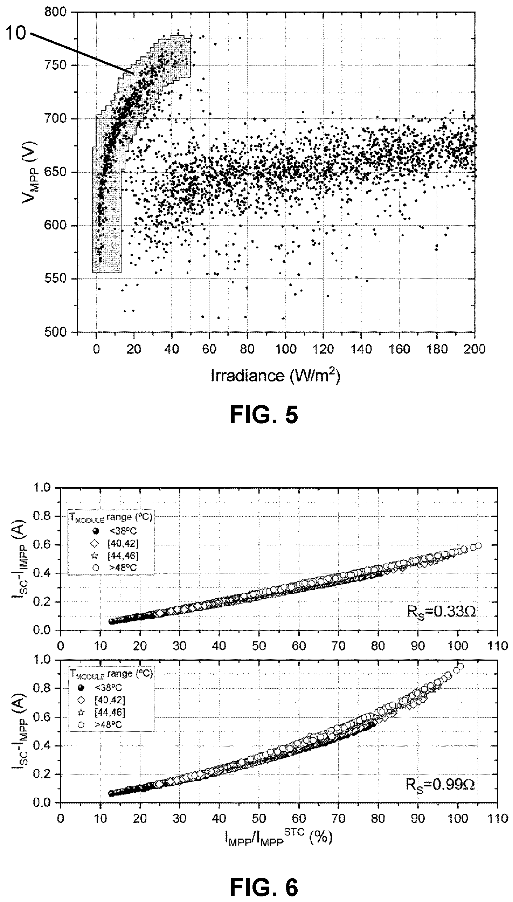

Figure 5 shows V_{MPP} of a PV device/system as measured by e.g. a photovoltaic inverter.

As it can be appreciated from the plot, which represents multiple V_{MPP} values for different in-plane irradiance, G, values, the V_{MPP} is considerably greater for low irradiances (e.g. G values below 50 W/m²) than for greater irradiances (e.g. G values above 50 W/m²).

By processing the V_{MPP} values for distinct irradiance levels, it can be determined which VMPP values corresponds to an open-circuit condition of the PV device/system. For example, the open-circuit voltage V_{OC} can be determined by means of a processor or processors running a clustering technique that at least identifies cluster 10 corresponding to V_{OC} values.

Figure 6 shows relationships between the difference I_{SC}-I_{MPP}, and I_{MPP} itself, as a function of temperature. In the top graph of Figure 6, the relationship is shown for a series resistance of 0.33 Ω whereas, in the bottom graph, the relationship is shown for a series resistance of 0.99 Ω.

For both values of R_{S}, the behavior of I_{SC}-I_{MPP} versus I_{MPP} is similar at different temperatures, and it increases with I_{MPP}. What is not similar is the behavior for the different R_{S} values.

For an R_{S} value of 0.33 Ω, the behavior of I_{SC}-I_{MPP} is linear or substantially linear. For R_{S} value of 0.99 Ω, the behavior of I_{SC}-I_{MPP} is not substantially linear.

Owing to said non-linear behavior that occurs for higher R_{S} values, e.g. starting from 0.6 Ω, the accuracy in the computation of R_{S} without considering I_{SC} in the computation tends to reduce, thereby increasing the error between the calculated value and the actual value for R_{S}.

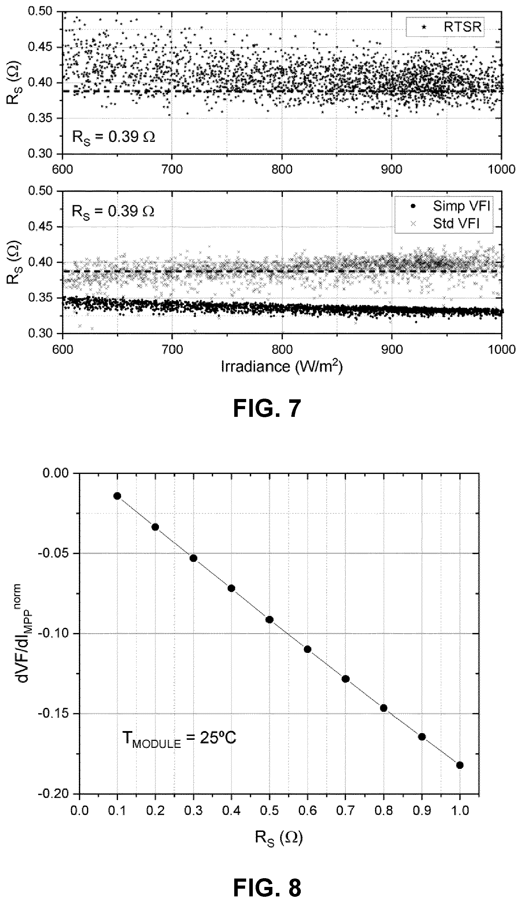

For this reason, it is preferable to at least consider I_{SC} in the R_{S} computations at least in these conditions in which R_{S} is relatively high. Notwithstanding, the computation of R_{S} also taking into account I_{SC} for lower R_{S} values, and the computation of R_{S} without taking into account I_{SC} for higher R_{S} values both fall within the scope of the present disclosure. It will be noted that although less accurate, the computation without I_{SC} is computationally simpler than the computation with I_{SC} and hence it may be convenient, in some occasions, to calculate R_{S} in this manner even if the result will have more error; further, as it will be described with reference to Figure 7, this way of computing R_{S} is also convenient for monitoring its evolution over time as it is more resilient against errors in the measurement of in-plane irradiance.

Figure 7 shows a comparison of calculated R_{S} values, at different irradiance levels, according to different embodiments and R_{S} values calculated with the RTSR method. The R_{S} values resulting from RTSR are on the top graph, and the R_{S} values resulting from the procedure of the present disclosure are on the bottom graph.

The graph represents the in-plane irradiance, G, in the horizontal axis, and the calculated R_{S} value in the vertical axis. The actual R_{S} value, which is 0.39 Ω, is plotted with a dashed line for comparison of the accuracy in the R_{S} values calculated with the different alternatives.

A technique according to embodiments of the present disclosure whereby I_{SC} of the PV device/system is not considered for the computation of R_{S} is labeled as Simp VFI, and it usually provides values that are below the actual R_{S} value with an average relative error in the order of 10%. The error increases as the irradiance increases due to a lower R_{S} value resulting from the computation made. The dispersion in the R_{S} calculation is low, meaning that the computed R_{S} values are steady. The reduced dispersion makes the technique suitable for monitoring R_{S} over time as variations in the value can be associated with a change in R_{S} rather than with an error in the calculation.

By contrast, the RTSR method has greater dispersion in the result, and provides R_{S} values above the actual value and below the actual value. The relative error is typically a little bit less than the previously mentioned technique; however, the dispersion is quite significant, making this method less sensitive to detection of failure modes.

A technique according to embodiments of the present disclosure whereby I_{SC} of the PV device/system is taken into account for the computation of R_{S} is labeled as Std VFI, and it outperforms both techniques. Particularly, this technique is capable of providing R_{S} values with a relative error that is less than 3%, and even less than 1%. Further, the dispersion is also low like with the technique labeled Simp VFI, so monitoring of R_{S} is possible and will provide accurate estimations of the status of the PV device/system.

Figure 8 shows the evolution of the partial derivative $\frac{\partial VF}{\partial {I}_{MPP}}$ as the series resistance R_{S} is increased for a simulated PV device/system.

The simulation is based on a physical model that provides I_{MPP}**-**V_{MPP} pairs for a wide range of operation conditions (in-plane irradiance and module temperature). In this particular case, for simplicity, an in-plane irradiance ranging from 0 to 1000 W/m² and a fixed module temperature of 25°C were considered during the simulation.

Specifically, the obtained results show that, for this particular case, the relationship between $\frac{\partial VF}{\partial {I}_{MPP}}$ and R_{S} could be expressed by means of a simple linear regression. Thus, a mathematical expression can be obtained that allows the assessment of the actual R_{S} of the PV device/system from the ∂*VF*/*∂I_{MPP}* calculated from experimental I_{MPP}-V_{MPP} data.

During operation of the PV device/system, a computing device obtains the value of the derivative of VF with respect to I_{MPP} and obtains the value of R_{S} from the predetermined model. Thus, by obtaining the value of the derivative of VF and/or monitoring the time evolution of the derivative of VF, determination and/or monitoring of the series resistance is made possible in some embodiments of the present disclosure.

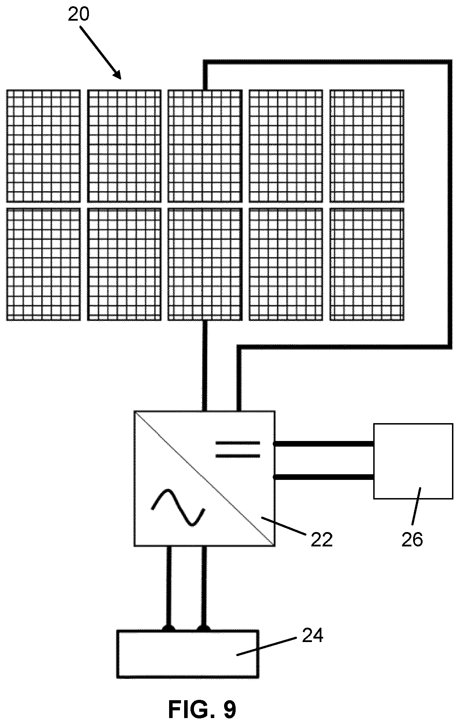

Figure 9 diagrammatically shows a system with an exemplary PV device/system 20 whose series resistance is monitored.

The system includes the PV device/system 20, in this example an array of PV modules, a PV inverter 22 electrically connected with both the PV device/system 20 and an electric grid 24, and also includes a computing device 26 that, in this example, is electrically connected with the PV inverter 22.

The PV inverter 22 provides data about the PV device/system 20 as known in the art. The computing device 26, which may additionally be electrically connected with the electric grid 24 and/or the PV device/system 20, obtains the data provided by the PV inverter 22.

The computing device 26 conducts a method as described in the present disclosure by way of one or more processors thereof and at least one memory thereof including instructions or computer program code for execution by the one or more processors. The computing device 26 thus determines the value of the series resistance R_{S} of the PV device/system 20 and/or monitors the evolution of R_{S} over time. The resulting value of values may be provided to other devices for notification and logging purposes, for example, and/or used by the computing device 26 itself for controlling the operation of the PV device/system 20, either directly or through the PV inverter 22.

In this text, the term "comprises" and its derivations (such as "comprising", etc.) should not be understood in an excluding sense, that is, these terms should not be interpreted as excluding the possibility that what is described and defined may include further elements, steps, etc.

On the other hand, the invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. A method comprising:
computing, by one or more processors, a partial derivative of a voltage factor, VF, of a photovoltaic device (20) or system with respect to a current at the maximum power generation I_{MPP}, of the photovoltaic device or system from either:
the voltage factor, VF, of the device or system, calculated by the one or more processors, as a ratio between: an open circuit voltage, V_{OC}, of the device or system, and a voltage at a maximum power generation, V_{MPP}, of the device or system; or
data representative of pairs of I_{MPP} and voltage at a maximum power generation, V_{MPP}, of the device or system at a plurality of operating conditions, with the I_{MPP} and V_{MPP} of each pair being at same operating conditions; **characterised in that** the method further comprises
computing, by the one or more processors, a value for a series resistance, R_{S}, of the device or system at least based on: the computed partial derivative of VF, and at least one predetermined model characterizing a relationship between the R_{S} of the device or system and the partial derivative of VF.

2. The method of claim 1, comprising:
calculating, by the one or more processors, the voltage factor, VF, of the photovoltaic device or system as a ratio between: an open circuit voltage, V_{OC}, of the device or system, and a voltage at a maximum power generation, V_{MPP}, of the device or system;
computing, by the one or more processors, a first ratio between: a product of a predetermined constant, n, associated with the device or system times a thermal voltage, V_{TH}, of the device or system for a predetermined temperature, and I_{MPP}; and
computing, by the one or more processors, a second ratio between V_{MPP} and V_{OC}; and wherein:
the computing, by the one or more processors, a partial derivative of a voltage factor, VF, of the photovoltaic device or system with respect to a current at the maximum power generation, I_{MPP}, of the photovoltaic device or system is from the voltage factor, VF, of the device or system, calculated by the one or more processors, as a ratio between: an open circuit voltage, V_{OC}, of the device or system, and a voltage at a maximum power generation, V_{MPP}, of the device or system; and
the computing, by the one or more processors, a value for a series resistance, R_{S}, of the device or system is at least based on: a product of the partial derivative of VF and V_{OC}; and a product of the first ratio and the second ratio.

3. The method of claim 2, wherein, in the step of computing the value for R_{S}, the value is a result of: ${R}_{S} = - {V}_{OC} ⋅ \frac{\partial VF}{\partial {I}_{MPP}} + \left(\frac{{nV}_{TH}}{{I}_{MPP}}\right) ⋅ \left(1-\frac{{V}_{MPP}}{{V}_{OC}}\right)$ where the predetermined constant n is an ideality factor of an electrical behavior of the device or system.

4. The method of claim 2, further comprising:
computing, by the one or more processors, a third ratio between: n times V_{TH}, and a difference between a short-circuit current, I_{SC}, of the device or system and I_{MPP}; and
computing, by the one or more processors, a partial derivative of a difference between I_{SC} and I_{MPP} with respect to I_{MPP};
wherein the value for R_{S} is at least further based on: a product of the third ratio and the partial derivative of the difference.

5. The method of claim 4, wherein, in the step of computing the value for R_{S}, the value is a result of: ${R}_{S} = - {V}_{OC} ⋅ \frac{\partial VF}{\partial {I}_{MPP}} + \left(\frac{{nV}_{TH}}{{I}_{MPP}}\right) ⋅ \left(\frac{{V}_{MPP}}{{V}_{OC}}\right) + \left(\frac{{nV}_{TH}}{{I}_{SC} - {I}_{MPP}}\right) ⋅ \left(\frac{\partial \left({I}_{SC}-{I}_{MPP}\right)}{\partial {I}_{MPP}}\right)$ where the predetermined constant n is an ideality factor of an electrical behavior of the device or system.

6. The method of any one of claims 4-5, wherein the difference between I_{SC} and I_{MPP} is modelled with a mathematical expression approximating the difference.

7. The method of claim 6, wherein the mathematical expression is a polynomial.

8. The method of any one of the preceding claims, further comprising:
comparing, by the one or more processors, the value for R_{S} with one or more predetermined thresholds; and
executing or issuing, by the one or more processors, at least one action or command based on a result of the step of comparing.

9. The method of any one of the preceding claims, wherein the step of computing the value for R_{S} is conducted a plurality of times over a period of time, thereby providing a time evolution of the values of R_{S}.

10. The method of claim 9, further comprising:
comparing, by the one or more processors, the time evolution, a time evolution of the values of VF, and/or a time evolution of the values of the partial derivative of VF with respect to I_{MPP} with one or more predetermined thresholds or predetermined curves; and
executing or issuing, by the one or more processors, at least one action or command based on a result of the step of comparing the time evolution.

11. The method of any one of claims 8-10, wherein the at least one action or command comprises one or more of: generating an alarm signal, transmitting an alarm signal to an electronic device, transmitting a request for maintenance tasks to an electronic device, reducing the electric current in the PV device or system preferably to put it in open circuit conditions, and actuating one or more electrical protection devices to disconnect the PV device/system from other PV devices/systems and/or from an electrical system.

12. The method of any one of the preceding claims, further comprising estimating, by the one or more processors, degradation of the R_{S} of the device or system by evaluating the partial derivative of VF with respect to I_{MPP}.

13. The method of any one of the preceding claims, wherein the photovoltaic device or system is or comprises one of the following photovoltaic devices or systems: a solar cell, a module, a string, an array, an inverter, and a combination thereof.

14. A data processing device or system comprising means for carrying out the method of any one of the preceding claims.

15. A computer program product or a data carrier signal carrying the computer program product, the computer program product having instructions which, when executed by a computing device, cause the computing device to perform a method according to any one of claims 1-13.

## Patentansprüche

1. Verfahren, umfassend:
Berechnen, durch einen oder mehrere Prozessoren, einer partiellen Ableitung eines Spannungsfaktors, VF, einer photovoltaischen Vorrichtung (20) oder eines Systems nach einem Strom bei maximaler Stromerzeugung, I_{MPP}, der photovoltaischen Vorrichtung oder des Systems aus entweder:
dem Spannungsfaktor, VF, der Vorrichtung oder Anlage, der von dem einen oder den mehreren Prozessoren berechnet wird, als Verhältnis zwischen: einer Leerlaufspannung, V_{OC}, der Vorrichtung oder Anlage und einer Spannung bei einer maximalen Stromerzeugung, V_{MPP}, der Vorrichtung oder Anlage; oder
Daten, die für Paare aus I_{MPP} und der Spannung bei einer maximalen Stromerzeugung, V_{MPP}, der Vorrichtung oder Anlage unter einer Vielzahl von Betriebsbedingungen repräsentativ sind, wobei I_{MPP} und V_{MPP} jedes Paares unter denselben Betriebsbedingungen vorliegen; **dadurch gekennzeichnet, dass** das Verfahren ferner umfasst,
Berechnen, durch den einen oder die mehreren Prozessoren, eines Wertes für einen Serienwiderstand, R_{S}, der Vorrichtung oder des Systems, zumindest basierend auf: der berechneten partiellen Ableitung von VF und mindestens einem vorbestimmten Modell, das eine Beziehung zwischen dem R_{S} der Vorrichtung oder des Systems und der partiellen Ableitung von VF kennzeichnet.

2. Verfahren nach Anspruch 1, umfassend:
Berechnen, durch den einen oder die mehreren Prozessoren, des Spannungsfaktors VF der photovoltaischen Vorrichtung oder des Systems als Verhältnis zwischen: einer Leerlaufspannung, V_{OC}, der Vorrichtung oder des Systems und einer Spannung bei einer maximalen Stromerzeugung,V_{MPP}, der Vorrichtung oder des Systems;
Berechnen, durch den einen oder die mehreren Prozessoren, eines ersten Verhältnisses zwischen:
einem Produkt aus einer vorbestimmten Konstante, n, die der Vorrichtung oder dem System zugeordnet ist, mal einer thermischen Spannung, V_{TH}, der Vorrichtung oder des Systems bei einer vorbestimmten Temperatur, und I_{MPP}; und
Berechnen, durch den einen oder die mehreren Prozessoren, eines zweiten Verhältnisses zwischen V_{MPP} und V_{OC}; und wobei:
die Berechnung, durch den einen oder die mehreren Prozessoren, einer partiellen Ableitung eines Spannungsfaktors, VF, der photovoltaischen Vorrichtung oder des Systems nach einem Strom bei maximaler Stromerzeugung, I_{MPP}, der photovoltaischen Vorrichtung oder des Systems, erfolgt anhand des Spannungsfaktors, VF, der Vorrichtung oder des Systems, der von dem einen oder den mehreren Prozessoren berechnet wird, als Verhältnis zwischen: einer Leerlaufspannung, V_{OC}, der Vorrichtung oder des Systems und einer Spannung bei einer maximaler Stromerzeugung, V_{MPP}, der Vorrichtung oder des Systems; und
die Berechnung, durch den einen oder die mehreren Prozessoren, eines Wertes für einen Serienwiderstand, R_{S}, der Vorrichtung oder des Systems zumindest auf Folgendem basiert: einem Produkt aus der partiellen Ableitung von VF und V_{OC};
und einem Produkt aus dem ersten Verhältnis und dem zweiten Verhältnis.

3. Verfahren nach Anspruch 2, wobei in dem Schritt des Berechnens des Wertes für R_{S} der Wert ein Ergebnis ist von: ${R}_{S} = - {V}_{OC} ⋅ \frac{\partial VF}{\partial {I}_{MPP}} + \left(\frac{{nV}_{TH}}{{I}_{MPP}}\right) ⋅ \left(1-\frac{{V}_{MPP}}{{V}_{OC}}\right)$ wobei die vorbestimmte Konstante n ein Idealitätsfaktor eines elektrischen Verhaltens der Vorrichtung oder des Systems ist.

4. Verfahren nach Anspruch 2, weiterhin umfassend:
Berechnungen, durch den einen oder die mehreren Prozessoren, eines dritten Verhältnisses zwischen: n-mal V_{TH} und einer Differenz zwischen einem Kurzschlussstrom, I_{SC}, der Vorrichtung oder des Systems und I_{MPP}; und
Berechnen, durch den einen oder die mehreren Prozessoren, einer partiellen Ableitung einer Differenz zwischen I_{SC} und I_{MPP} nach I_{MPP};
wobei der Wert für R_{S} zumindest ferner basiert auf: einem Produkt aus dem dritten Verhältnis und der partiellen Ableitung der Differenz.

5. Verfahren nach Anspruch 4, wobei in dem Schritt des Berechnens des Wertes für R_{S} der Wert ein Ergebnis ist von: ${R}_{S} = - {V}_{OC} ⋅ \frac{\partial VF}{\partial {I}_{MPP}} + \left(\frac{n {V}_{TH}}{{I}_{MPP}}\right) ⋅ \left(\frac{{V}_{MPP}}{{V}_{OC}}\right) + \left(\frac{n {V}_{TH}}{{I}_{SC} - {I}_{MPP}}\right) ⋅ \left(\frac{\partial \left({I}_{SC}-{I}_{MPP}\right)}{\partial {I}_{MPP}}\right)$ wobei die vorbestimmte Konstante n ein Idealitätsfaktor eines elektrischen Verhaltens der Vorrichtung oder des Systems ist.

6. Verfahren nach einem der Ansprüche 4-5, wobei die Differenz zwischen I_{SC} und I_{MPP} mit einem mathematischen Ausdruck modelliert wird, der die Differenz approximiert.

7. Verfahren nach Anspruch 6, wobei der mathematische Ausdruck ein Polynom ist.

8. Verfahren nach einem der vorstehenden Ansprüche, weiterhin umfassend:
Vergleichen, durch den einen oder die mehreren Prozessoren, des Wertes für R_{S} mit einem oder mehreren vorbestimmten Schwellenwerten; und
Ausführen oder Ausgeben, durch den einen oder die mehreren Prozessoren, mindestens einer Aktion oder eines Befehls auf der Grundlage eines Ergebnisses des Schritts des Vergleichens.

9. Verfahren nach einem der vorstehenden Ansprüche, wobei der Schritt des Berechnens des Wertes für R_{S} über einen Zeitraum hinweg mehrfach durchgeführt wird, wodurch eine zeitliche Entwicklung der Werte von R_{S} bereitgestellt wird.

10. Verfahren nach Anspruch 9, weiterhin umfassend:
Vergleichen, durch den einen oder die mehreren Prozessoren, der zeitlichen Entwicklung, einer zeitlichen Entwicklung der Werte von VF und/oder einer zeitlichen Entwicklung der Werte der partiellen Ableitung von VF nach I_{MPP} mit einem oder mehreren vorgegebenen Schwellenwerten oder vorgegebenen Kurven; und
Ausführen oder Ausgeben, durch den einen oder die mehreren Prozessoren, mindestens einer Aktion oder eines Befehls auf der Grundlage eines Ergebnisses des Schritts des Vergleichens der zeitlichen Entwicklung.

11. Verfahren nach einem der Ansprüche 8 - 10, wobei die mindestens eine Aktion oder ein Befehl eines oder mehreres umfassen: Erzeugen eines Alarmsignals, Übertragung eines Alarmsignals an ein elektronisches Gerät, Senden einer Anforderung für Wartungsaufgaben an ein elektronisches Gerät, Verringern des elektrischen Stroms in der PV-Vorrichtung oder dem PV-System, vorzugsweise um diese in einen offenen Stromkreis zu versetzen, und Betätigen einer oder mehrerer elektrischer Schutzvorrichtungen, um die PV-Anlage/das PV-System von anderen PV-Vorrichtungen/-Systemen und/oder von einem elektrischen System zu trennen.

12. Verfahren nach einem der vorstehenden Ansprüche, weiterhin umfassend das Schätzen, durch einen oder die mehreren Prozessoren, der Verschlechterung von R_{S} der Vorrichtung oder das Systems, indem die partielle Ableitung von VF nach I_{MPP} ausgewertet wird.

13. Verfahren nach einem der vorstehenden Ansprüche, wobei die photovoltaische Vorrichtung oder das System eine der folgenden photovoltaischen Vorrichtungen oder Systeme ist oder umfasst: eine Solarzelle, ein Modul, einen Strang, eine Anordnung, einen Wechselrichter und eine Kombination davon.

14. Datenverarbeitungsvorrichtung oder -system, umfassend Mittel zur Durchführung des Verfahrens nach einem der vorstehenden Ansprüche.

15. Ein Computerprogrammprodukt oder ein Datenträgersignal, das das Computerprogrammprodukt trägt, wobei das Computerprogrammprodukt Anweisungen aufweist, die, wenn sie von einer Rechenvorrichtung ausgeführt werden, bewirken, dass die Rechenvorrichtung ein Verfahren gemäß einem der Ansprüche 1 bis 13 ausführt.

## Revendications

1. Méthode comprenant :
le calcul, par un ou plusieurs processeurs, d'une dérivée partielle d'un facteur de tension, VF, d'un dispositif (20) ou système photovoltaïque par rapport à un courant à la production de puissance maximale, I_{MPP}, du dispositif ou système photovoltaïque à partir de l'un ou l'autre des éléments suivants :
le facteur de tension, VF, du dispositif ou système, calculé par les un ou plusieurs processeurs, sous la forme d'un rapport entre : une tension en circuit ouvert, V_{OC}, du dispositif ou système et une tension à une production de puissance maximale, V_{MPP}, du dispositif ou système ; ou
des données représentatives de paires I_{MPP} et tension à une production de puissance maximale, V_{MPP}, du dispositif ou système dans une pluralité de conditions de fonctionnement, les I_{MPP} et V_{MPP} de chaque paire se présentant aux mêmes conditions de fonctionnement ;
**caractérisée en ce que** la méthode comprend en outre
le calcul, par les un ou plusieurs processeurs, d'une valeur d'une résistance en série, R_{S}, du dispositif ou système en se basant au moins sur : la dérivée partielle calculée de VF et au moins un modèle prédéterminé caractérisant une relation entre la R_{S} du dispositif ou système et la dérivée partielle de VF.

2. Méthode selon la revendication 1, comprenant :
le calcul, par les un ou plusieurs processeurs, du facteur de tension, VF, du dispositif ou système photovoltaïque sous la forme d'un rapport entre : une tension en circuit ouvert, Voc, du dispositif ou système et une tension à une production de puissance maximale, V_{MPP}, du dispositif ou système ;
le calcul, par les un ou plusieurs processeurs, d'un premier rapport entre : un produit d'une constante n prédéterminée associée au dispositif ou système fois une tension thermique, V_{TH}, du dispositif ou système pour une température prédéterminée, et I_{MPP} ; et
le calcul, par les un ou plusieurs processeurs, d'un deuxième rapport entre V_{MPP} et Voc ; et dans laquelle :
le calcul, par les un ou plusieurs processeurs, d'une dérivée partielle d'un facteur de tension, VF, du dispositif ou système photovoltaïque par rapport à un courant à la production de puissance maximale, I_{MPP}, du dispositif ou système photovoltaïque provient du facteur de tension, VF, du dispositif ou système, calculé par les un ou plusieurs processeurs sous la forme d'un rapport entre : une tension en circuit ouvert, Voc, du dispositif ou système et une tension à une production de puissance maximale, V_{MPP}, du dispositif ou système ; et
le calcul, par les un ou plusieurs processeurs, d'une valeur d'une résistance en série, R_{S}, du dispositif ou système est au moins basé sur : un produit de la dérivée partielle de VF et Voc ; et un produit du premier rapport et du deuxième rapport.

3. Méthode selon la revendication 2, dans laquelle, à l'étape de calcul de la valeur de R_{S}, la valeur est un résultat de : ${R}_{S} = - {V}_{OC} ⋅ \frac{\partial VF}{\partial {I}_{MPP}} + \left(\frac{{nV}_{TH}}{{I}_{MPP}}\right) ⋅ \left(1-\frac{{V}_{MPP}}{{V}_{OC}}\right)$ où la constante prédéterminée *n* est un facteur d'idéalité d'un comportement électrique du dispositif ou système.

4. Méthode selon la revendication 2, comprenant en outre :
le calcul, par les un ou plusieurs processeurs, d'un troisième rapport entre : *n* fois V_{TH}, et une différence entre un courant de court-circuit, I_{SC}, du dispositif ou système et I_{MPP} ; et
le calcul, par les un ou plusieurs processeurs, d'une dérivée partielle d'une différence entre I_{SC} et I_{MPP} par rapport à I_{MPP} ;
dans laquelle la valeur de R_{S} est en outre au moins basée sur : un produit du troisième rapport et de la dérivée partielle de la différence.

5. Méthode selon la revendication 4, dans laquelle, à l'étape de calcul de la valeur de R_{S}, la valeur est un résultat de : ${R}_{S} = - {V}_{OC} ⋅ \frac{\partial VF}{\partial {I}_{MPP}} + \left(\frac{{nV}_{TH}}{{I}_{MPP}}\right) ⋅ \left(\frac{{V}_{MPP}}{{V}_{OC}}\right) + \left(\frac{{nV}_{TH}}{{I}_{SC} - {I}_{MPP}}\right) ⋅ \left(\frac{\partial \left({I}_{SC}-{I}_{MPP}\right)}{\partial {I}_{MPP}}\right)$ où la constante prédéterminée *n* est un facteur d'idéalité d'un comportement électrique du dispositif ou système.

6. Méthode selon l'une quelconque des revendications 4 et 5, dans laquelle la différence entre I_{SC} et I_{MPP} est modélisée à l'aide d'une expression mathématique qui donne une approximation de la différence.

7. Méthode selon la revendication 6, dans laquelle l'expression mathématique est un polynôme.

8. Méthode selon l'une quelconque des revendications précédentes, comprenant en outre :
la comparaison, par les un ou plusieurs processeurs, de la valeur de R_{S} avec un ou plusieurs seuils prédéterminés ; et
l'exécution ou l'émission, par les un ou plusieurs processeurs, d'au moins une action ou instruction sur la base d'un résultat de l'étape de la comparaison.

9. Méthode selon l'une quelconque des revendications précédentes, dans laquelle l'étape de calcul de la valeur de R_{S} est effectuée plusieurs fois sur une période de temps, ce qui permet d'obtenir un évolution dans le temps des valeurs de R_{S}.

10. Méthode selon la revendication 9, comprenant en outre :
la comparaison, par les un ou plusieurs processeurs, de l'évolution dans le temps, d'une évolution dans le temps des valeurs de VF, et/ou d'une évolution dans le temps des valeurs de la dérivée partielle de VF par rapport à I_{MPP} avec un ou plusieurs seuils prédéterminés ou courbes prédéterminées ; et
l'exécution ou l'émission, par les un ou plusieurs processeurs, d'au moins une action ou instruction sur la base d'un résultat de l'étape de la comparaison de l'évolution dans le temps.

11. Méthode selon l'une quelconque des revendications 8 à 10, dans laquelle l'au moins une action ou instruction comprend une ou plusieurs des opérations suivantes : générer un signal d'alarme, transmettre un signal d'alarme à un dispositif électronique, transmettre une demande de tâches de maintenance à un dispositif électronique, réduire le courant électrique dans le dispositif ou système PV, de préférence pour le mettre dans des conditions de circuit ouvert, et actionner un ou plusieurs dispositifs de protection électrique pour déconnecter le dispositif/système PV d'autres dispositifs/systèmes PV et/ou d'un système électrique.

12. Méthode selon l'une quelconque des revendications précédentes, comprenant en outre l'estimation, par les un ou plusieurs processeurs, de la dégradation de la R_{S} du dispositif ou système en évaluant la dérivée partielle de VF par rapport à I_{MPP}.

13. Méthode selon l'une quelconque des revendications précédentes, dans laquelle le dispositif ou système photovoltaïque est ou comprend l'un des dispositifs ou systèmes photovoltaïques suivants : une cellule solaire, un module, une chaîne, un réseau, un onduleur, et une combinaison de ceux-ci.

14. Dispositif ou système de traitement de données comprenant des moyens pour mettre en œuvre la méthode selon l'une quelconque des revendications précédentes.

15. Produit de programme informatique ou signal porteur de données portant le produit de programme informatique, le produit de programme informatique ayant des instructions qui, lorsqu'elles sont exécutées par un dispositif informatique, amènent le dispositif informatique à mettre en œuvre une méthode selon l'une quelconque des revendications 1 à 13.
